Europäisches Patentamt

European Patent Office

Office européen des brevets

(19)

(11) Publication number: 0 518 550 A2

# EUROPEAN PATENT APPLICATION

(12)

(21) Application number: 92305093.4

(22) Date of filing: 03.06.92

(51) Int. Cl.⁵: **G06F 11/26**, G06F 11/28, G01R 31/28

(30) Priority: **10.06.91 US 713489**

(43) Date of publication of application:
**16.12.92 Bulletin 92/51**

(84) Designated Contracting States:
**DE FR GB**

(71) Applicant: **International Business Machines
Corporation
Old Orchard Road
Armonk, N.Y. 10504(US)**

(72) Inventor: **Fuoco, Daniel Paul
21570 Red Bay Road
Boca Raton, Florida 33433(US)**
Inventor: **Hernandez, Luis Antonio**

**P.O. Box 2103
Boca Raton, Florida 33427-2103(US)**
Inventor: **Mathisen, Eric
800 NW 7th Street
Boca Raton, Florida 33486(US)**
Inventor: **Raymond, Jonathan Henry
RR2 Box 62394
Underhill, Vermont 05489(US)**
Inventor: **Tashakori, Esmaeil
2935 S W 22nd Avenue No. 102
Delray Beach, Florida 33445(US)**

(74) Representative: **Blakemore, Frederick Norman
IBM United Kingdom Limited Intellectual
Property Department Hursley Park
Winchester Hampshire SO21 2JN(GB)**

(54) **Integrated circuit device.**

(57) This invention relates to integrated circuit devices and, more particularly, to the testing of the connection of such devices with a printed circuit board device such as a personal computer planar board. The invention contemplates in circuit testing of very large scale integrated (VLSI) devices having timing critical functions by use of controllable bi-directional driver/receivers associated with timing critical function pins.

Fig. 6

The present invention relates to integrated circuit devices and, more particularly, to the testing of the connection of such devices with a printed circuit board device such as personal computer planar board. The invention contemplates in circuit testing of very large scale integrated (VLSI) devices having timing critical functions by use of controllable bi-directional driver/receivers associated with timing critical function pins.

Personal computer systems in general and IBM personal computers in particular have attained widespread use for providing computer power to many segments of today's modern society. Personal computer systems can usually be defined as a desk top, floor standing, or portable microcomputer that consists of a system unit having a single system processor and associated volatile and non-volatile memory, a display monitor, a keyboard, one or more diskette drives, a fixed disk storage, and an optional printer. One of the distinguishing characteristics of these systems is the use of a motherboard or system planar to electrically connect these components together. These systems are designed primarily to give independent computing power to a single user and are inexpensively priced for purchase by individuals or small businesses. Examples of such personal computer systems are IBM's PERSONAL COMPUTER AT and IBM's PERSONAL SYSTEM/2 Models 25, 30, L40SX, 50, 55, 65, 70, 80, 90 and 95.

These systems can be classified into two general families. The first family, usually referred to as Family I Models, use a bus architecture exemplified by the IBM PERSONAL COMPUTER AT and other "IBM compatible" machines. The second family, referred to as Family II Models, use IBM's MICRO CHANNEL bus architecture exemplified by IBM's PERSONAL SYSTEM/2 Models 50 through 95. The Family I models typically have used the popular INTEL 8088 or 8086 microprocessor as the system processor. These processors have the ability to address one megabyte of memory. The Family II models typically use the high speed INTEL 80286, 80386, and 80486 microprocessors which can operate in a real mode to emulate the slower speed INTEL 8086 microprocessor or a protected mode which extends the addressing range from 1 megabyte to 4 Gigabytes for some models. In essence, the real mode feature of the 80286, 80386, and 80486 processors provide hardware compatibility with software written for the 8086 and 8088 microprocessors.

Personal computer systems such as those described share with a multiplicity of other electronic devices the characteristics of using VLSI devices mounted on printed circuit boards. Indeed, the planar board, and at least certain of the microprocessors, described above meet such characteristics. Typically, a personal computer uses a number of VLSI devices in addition to the microprocessor by which such a computer is often characterized. In all such devices, there are problems associated with testing printed circuit boards to assure that manufacturing quality is maintained and the manufactured apparatus is properly operable. One specific manufacturing error which can arise, and which can be particularly troublesome to test and identify, is improper soldering or other connection between conductive pathways which pass signals among devices mounted on a printed circuit board and the pins by which such signals reach the circuit elements of the VLSI device which provide the functionality of the device.

In the past, testing techniques have relied upon what is known as input/output (or I/O) mapping. In this technique, signals are applied to certain pins of a VLSI device and the output which occurs on other pins is noted. If the I/O responses are "mapped" so that a known output from a known pin will occur if proper connection is made to a known input pin, then such a test will properly evaluate the connection between the printed circuit board and the VLSI device.

While I/O mapping has been successful as a testing technique, many VLSI devices include circuit elements as to which there are critical timing dependencies for normal operation of the device. The presence of such timing critical elements and their associated pins limits the usefulness of I/O mapping tests due to the unacceptability of multiplexor and other delays necessarily inserted to enable such testing.

In accordance with the present invention there is now provided an integrated circuit device comprising: a package; a plurality of pins extending from the package for providing input and output pathways for signals to and from the device; a substrate housed within the package; and a plurality of circuit elements located on the substrate and connected to one another and to the pins, certain ones of the circuit elements and corresponding ones of the pins having functionally critical timing dependencies; characterised in that the device further includes bidirectional driver/receiver elements interposed between corresponding pins and the certain ones of the circuit elements for permitting normal functional passage of signals in one direction through the corresponding pins and for permitting testing of connections between the device and conductive pathways of a printed circuit board by passage of signals in the opposite direction through the corresponding pins in response to incircuit test control signals.

The present invention stems from a realisation that, to accommodate I/O mapping testing of connections between conductive pathways on a printed circuit board and timing critical pins on an integrated circuit device mounted on the board, the timing critical pins and associated circuit elements of an integrated circuit device can be provided with controllable, bi-directional driver/receivers which may be controlled by test signals applied to the board and device.

A preferred embodiment of the present invention will now be described with reference to the accompanying drawings, in which:

Figure 1 is a perspective view of a personal computer embodying this invention;

Figure 2 is an exploded perspective view of certain elements of the personal computer of Figure 1 including a chassis, a cover, and a planar board and illustrating certain relationships among those elements;

Figure 3 is a block diagram of components of the personal computer;

Figure 4 is a block diagram of a prior art connection between a functional path of a printed circuit board and an integrated circuit device mounted thereon;

Figure 5 is a block diagram of another prior art connection for I/O mapping testing;

Figure 6 is block diagram of a connection of the present invention for testing I/O mapping testing;

Figure 7 is a block diagram of yet another prior art connection for I/O mapping testing;

Figure 8 is a block diagram of still another prior art connection for I/O mapping testing; and

Figure 9 is a block diagram of another connection of the present invention for I/O mapping testing.

While the present invention will be described more fully hereinafter with reference to the accompanying drawings, in which a preferred embodiment of the present invention is shown, it is to be understood at the outset of the description which follows that persons of skill in the appropriate arts may modify the present invention here described while still achieving the favorable results of the present invention. Accordingly, the description which follows is to be understood as being a broad, teaching disclosure directed to persons of skill in the appropriate arts, and not as limiting upon the present invention.

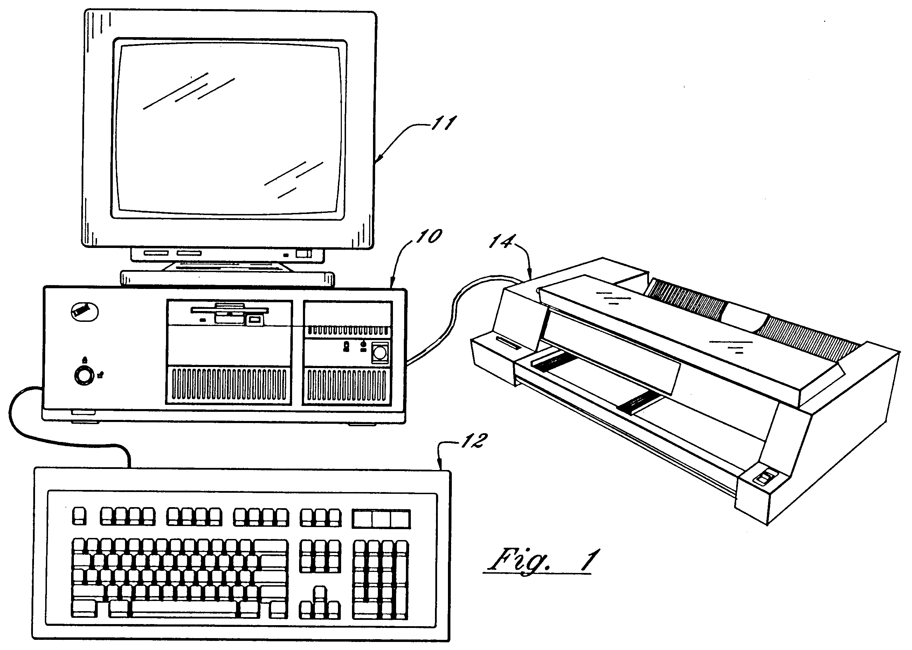

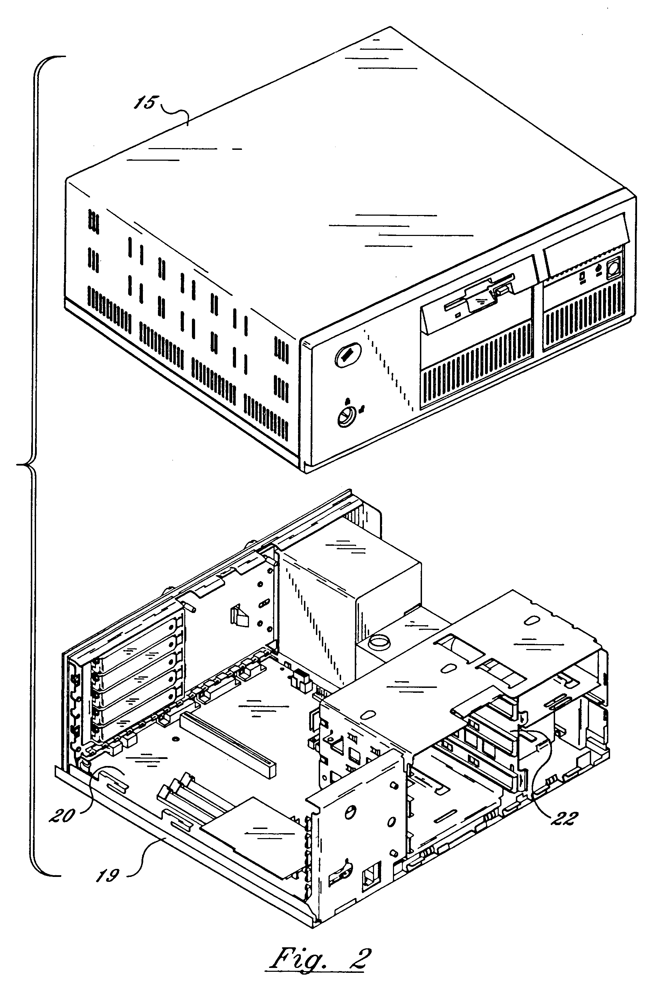

Referring now more particularly to the accompanying drawings, a microcomputer embodying the present invention is there shown and generally indicated at 10 (Figure 1). As mentioned hereinabove, the computer 10 may have an associated monitor 11, keyboard 12 and printer or plotter 14. The computer 10 has a cover 15 which cooperates with a chassis 19 in defining an enclosed, shielded volume for receiving electrically powered data processing and storage components for processing and storing digital data, as shown in Figure 2. At least certain of these components are mounted on a multilayer planar 20 or motherboard which is mounted on the chassis 19 and provides a means for electrically interconnecting the components of the computer 10 including those identified above and such other associated elements as floppy disk drives, various forms of direct access storage devices, accessory cards or boards, and the like. The personal computer system 10, and the planar board 20 and integrated circuit devices mounted thereon, are disclosed here as being an environment in which the present invention has particular utility and has been embodied. However, the interested reader should understand at the outset of the description which follows that the integrated circuit device structure to be described, and its implementation, will have usefulness far beyond personal computer systems. Indeed, the inventive characteristics to be described will find utility in a very wide range of integrated circuit devices and an equally wide range of types of printed circuit boards.

The chassis 19 has a base and a rear panel (Figure 2) and defines at least one open bay for receiving a data storage device such as a disk drive for magnetic or optical disks, a tape backup drive, or the like. In the illustrated form, an upper bay 22 is adapted to receive peripheral drives of a first size (such as those known as 3.5 inch drives). A floppy disk drive, a removable media direct access storage device capable of receiving a diskette inserted thereinto and using the diskette to receive, store and deliver data as is generally known, may be provided in the upper bay 22.

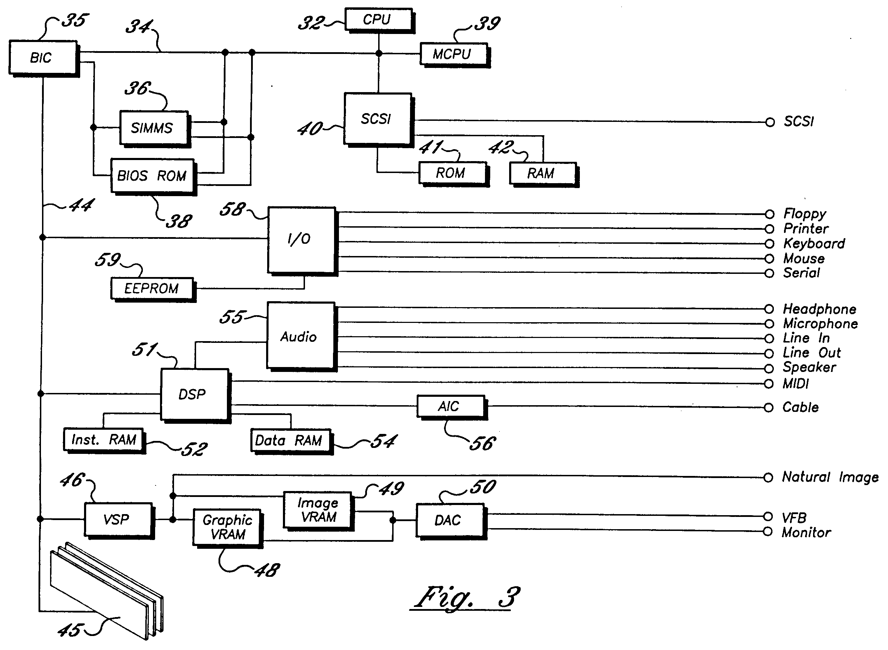

Prior to relating the above structure to the present invention, a summary of the operation in general of the personal computer system 10 may merit review. Referring to Figure 3, there is shown a block diagram of a personal computer system illustrating the various components of the computer system such as the system 10 in accordance with the present invention, including components mounted on the planar 20 and the connection of the planar to the I/O slots and other hardware of the personal computer system. Connected to the planar is the system processor 32. While any appropriate microprocessor can be used as the CPU 32, one suitable microprocessor is the 80386 which is sold by INTEL. The CPU 32 is connected by a high speed CPU local bus 34 to a bus interface control unit 35, to volatile random access memory (RAM) 36 here shown as Single Inline Memory Modules (SIMMs) and to BIOS ROM 38 in which is stored instructions for basic input/output operations to the CPU 32. The BIOS ROM 38 includes the BIOS that is used to interface between the I/O devices and the operating system of the microprocessor 32. Instructions stored in ROM 38 can be copied into RAM 36 to decrease the execution time of BIOS.

While the present invention is described hereinafter with particular reference to the system block diagram of Figure 3, it is to be understood at the outset of the description which follows that it is contemplated that the apparatus and methods in accordance with the present invention may be used with other hardware configurations of the planar board. For example, the system processor could be an Intel 80286 or 80486 microprocessor.

Returning now to Figure 3, the CPU local bus 34 (comprising data, address and control components) also provides for the connection of the microprocessor 32 with a math coprocessor 39 and a Small Computer Systems Interface (SCSI) controller 40. The SCSI controller 40 may, as is known to persons skilled in the arts of computer design and operation, be connected or connectable with Read Only Memory (ROM) 41, RAM 42, and suitable external devices of a variety of types as facilitated by the I/O connection indicated to the right in the Figure. The SCSI controller 40 functions as a storage controller in controlling storage memory devices such as fixed or removable media electromagnetic storage devices (also known as hard and floppy disk drives), electro-optical, tape and other storage devices.

The bus interface controller (BIC) 35 couples the CPU local bus 34 with an I/O bus 44. By means of the bus 44, the BIC 35 is coupled with an optional feature bus such as a MICRO CHANNEL bus having a plurality of I/O slots for receiving MICRO CHANNEL adapter cards 45 which may be further connected to an I/O device or memory (not shown). The I/O bus 44 includes address, data, and control components.

Coupled along the I/O bus 44 are a variety of I/O components such as a video signal processor 46 which is associated with video RAM (VRAM) for storing graphic information (indicated at 48) and for storing image information (indicated at 49). Video signals exchanged with the processor 46 may be passed through a Digital to Analog Converter (DAC) 50 to a monitor or other display device. Provision is also made for connecting the VSP 46 directly with what is here referred to as a natural image input/output, which may take the form of a video recorder/player, camera, etc. The I/O bus 44 is also coupled with a Digital Signal Processor (DSP) 51 which has associated instruction RAM 52 and data RAM 54 available to store software instructions for the processing of signals by the DSP 51 and data involved in such processing. The DSP 51 provides for processing of audio inputs and outputs by the provision of an audio controller 55, and for handling of other signals by provision of an analog interface controller 56. Lastly, the I/O bus 44 is coupled with a input/output controller 58 with associated Electrical Erasable Programmable Read Only Memory (EEPROM) 59 by which inputs and outputs are exchanged with conventional peripherals including floppy disk drives, a printer or plotter 14, keyboard 12, a mouse or pointing device (not shown), and by means of a serial port. As the knowledgeable reader will recognize, a number of the devices mentioned above will find their useful embodiments in integrated circuit devices. One specific example, and for which the present invention was first developed, is the BIC 35.

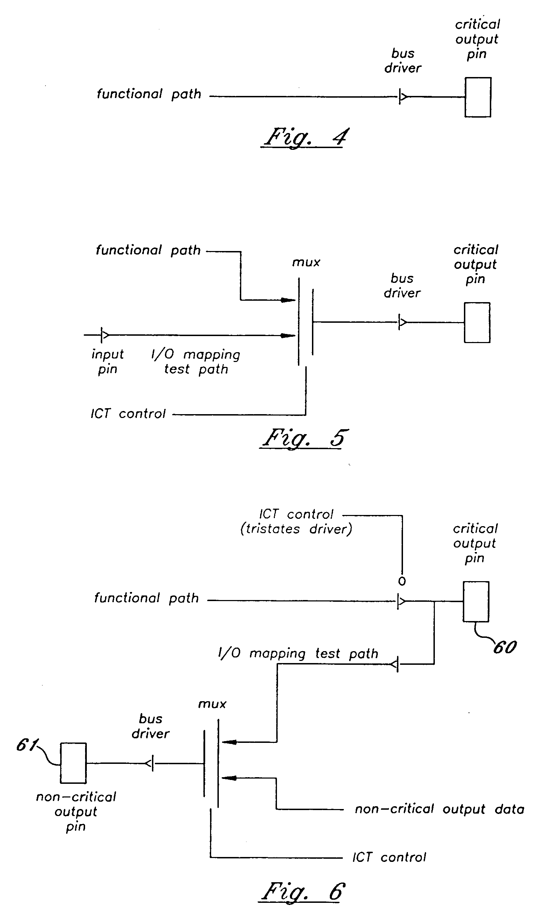

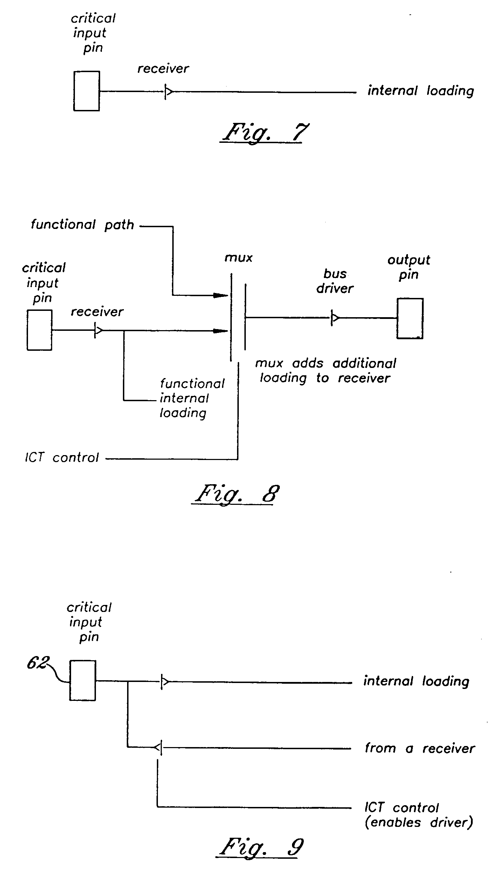

As has been alluded to hereinabove, in circuit testing of VLSI chip inputs and outputs has been enhanced heretofore by the use of I/O mapping. I/O mapping, as a testing technique, is designed to enable a fast method of testing and isolating failures of contact between a chip and the printed circuit board (PCB) mounting the chip during manufacturing. Stated differently, direct mapping of inputs to outputs eases test pattern generation and failure analysis for VLSI components after placement of the components on a PCB. Where a VLSI device is mounted without any special provision for such testing, the prior arrangements have been as indicated in Figure 4 (for an output pin) and Figure 7 (for an input pin). I/O mapping testing techniques normally place a multiplexor (or mux) in a signal line on the VLSI device, and place that mux under the control of an in circuit test (ICT) signal. In order to test an output signal, the mux is used to direct an input test signal from an input pin to the output pin. Inputs are tested by gating them to an output, adding additional capacitance and slowing the signal. Such prior arrangements have been illustrated in Figure 5 (for an output pin) and Figure 8 (for an input pin). Unfortunately, the insertion of a mux adds a delay to the existing data path for the output pin, and adds additional loading to the receiver element for an input pin which delays that existing data path. As a consequence, I/O mapping testing technology has been limited to pins which are non-critical as to signal timing. Timing critical outputs and inputs (for example clock lines) are unable to bear the additional burdens thus imposed.

In order to permit testing of timing critical pins while avoiding the imposition of additional burdens as described above, the present invention contemplates designing each critical pin as a bi-directional pin. Since that which is to be tested is the electrical contact between the pin and a board in which the device is mounted, the direction of testing current flow is insignificant. Output signals can be tested as inputs, and inputs as outputs. The need to multiplex an input signal to an output is eliminated, as is the need to load the receiver portion of a critical input. This is illustrated and described hereinafter with reference to testing of both output and input crticial pins.

Referring now to Figure 6, the present invention is there illustrated by the testing of a critical output pin 60 by mapping a test path to a non-critical output pin 61. In accordance with this invention, an in circuit test apparatus external to the board and device applies a control signal which tristates the driver for the pin, or causes the driver to present a high impedance effectively isolating the pin 60 from the functional path within the device. By so isolating the pin 60, a signal applied to that pin as an input is routed through the mapping test path provided to a multiplexor associated with the non-critical output pin 61 which, again under the control of the ICT, passes the test signal to the output pin verifying contact of both pins with the mounting circuit board.

The testing of a critical input pin 62 is illustrated in Figure 9. There, the ICT control enables a driver which permits the pin 62 to function as an output pin for purposes of testing, by passing a signal from a receiver within the device.

## Claims

1. An integrated circuit device comprising: a package; a plurality of pins extending from the package for providing input and output pathways for signals to and from the device; a substrate housed within the package; and a plurality of circuit elements located on the substrate and connected to one another and to the pins, certain ones of the circuit elements and correponding ones of the pins having functionally critical timing dependencies;

   characterised in that the device further includes bidirectional driver/receiver elements interposed between corresponding pins and the certain ones of the circuit elements for permitting normal functional passage of signals in one direction through the corresponding pins and for permitting testing of connections between the device and conductive pathways of a printed circuit board by passage of signals in the opposite direction through the corresponding pins in response to incircuit test control signals.

2. A printed circuit device comprising: a printed circuit board; a plurality of conductive pathways supported by the board; and an integrated circuit device as claimed in claim 1.

3. A computer system comprising a printed circuit device as claimed in claim 2.

4. An integrated circuit device comprising:

   a package;

   a plurality of pins extending from said package for providing input and output pathways for signals exchanged with said device;

   a substrate housed within said package; and

   a plurality of connected circuit elements operatively associated with said substrate and with one another for performing determinable functions, said circuit elements being operatively associated with said pins for exchange of signals therethrough,

   certain ones of said plurality of circuit elements and corresponding ones of said plurality of pins having functionally critical timing dependencies, and

   said certain ones of said circuit elements including bi-directional driver/receiver elements interposed between a corresponding pin and others of said certain ones of said circuit elements, said driver/receiver elements being available for incircuit test control signals enabling and disabling said driver/receiver elements for permitting normal functional passage of signals in one direction through an associated pin and for permitting testing by passage of signals in an opposite direction through an associated pin.

5. A printed circuit device comprising:

   a printed circuit board;

   a plurality of conductive pathways supported by said board for connection to an integrated circuit device;

   an integrated circuit device mounted in said board and accommodating testing of connections between said device and said conductive pathways, said device comprising:

   a package;

   a plurality of pins extending from said package for providing input and output pathways for signals exchanged with said conductive pathways;

   a substrate housed within said package; and

   a plurality of connected circuit elements operatively associated with said substrate and with one another for performing determinable functions, said circuit elements being operatively associated with said pins for exchange of signals therethrough,

certain ones of said plurality of circuit elements and corresponding ones of said plurality of pins having functionally critical timing dependencies, and

said certain ones of said circuit elements including bi-directional driver/receiver elements interposed between a corresponding pin and others of said certain ones of said circuit elements, said driver/receiver elements being available for incircuit test control signals applied through said conductive pathways for enabling and disabling said driver/receiver elements for permitting normal functional passage of signals in one direction through an associated pin and for permitting testing by passage of signals in an opposite direction through an associated pin.

6. A personal computer comprising:

a planar board;

a plurality of conductive pathways supported by said board for connection to a plurality of integrated circuit devices;

an integrated circuit device mounted in said board and accommodating testing of connections between said device and said conductive pathways, said device comprising:

a package;

a plurality of pins extending from said package for providing input and output pathways for signals exchanged with said conductive pathways;

a substrate housed within said package; and

a plurality of connected circuit elements operatively associated with said substrate and with one another for performing determinable functions, said circuit elements being operatively associated with said pins for exchange of signals therethrough,

certain ones of said plurality of circuit elements and corresponding ones of said plurality of pins having functionally critical timing dependencies, and

said certain ones of said circuit elements including bi-directional driver/receiver elements interposed between a corresponding pin and others of said certain ones of said circuit elements, said driver/receiver elements being available for incircuit test control signals applied through said conductive pathways for enabling and disabling said driver/receiver elements for permitting normal functional passage of signals in one direction through an associated pin and for permitting testing by passage of signals in an opposite direction through an associated pin.

7. A method of preparing an integrated circuit device for testing for proper connection with a printed circuit device in which the integrated circuit device is mounted comprising the steps of:

providing a substrate;

forming on said substrate a plurality of connected circuit elements operatively associated with one another for performing determinable functions;

forming certain ones of said plurality of circuit elements to have functionally critical timing dependencies and to include bi-directional driver/receiver elements interposed between a said certain ones and others of said certain ones of said circuit elements, said driver/receiver elements being available for incircuit test control signals enabling and disabling said driver/receiver elements for permitting normal functional passage of signals in one direction and for permitting testing by passage of signals in an opposite direction;

enclosing said substrate and said circuit elements in a package having a plurality of pin connectors; and

connecting pins with corresponding circuit elements for normal functional passage of signals in one direction and for permitting testing by passage of signals in an opposite direction.

8. A method of testing a printed circuit device for proper connection of the pins provided on an integrated circuit device mounted on the printed circuit device and comprising the steps of:

providing an integrated circuit device having:

a package;

a plurality of pins extending from the package for providing input and output pathways for signals exchanged with the integrated circuit device;

a substrate housed within the package; and

a plurality of connected circuit elements operatively associated with the substrate and with one another for performing determinable functions, the circuit elements being operatively associated with the pins for exchange of signals therethrough, certain ones of the plurality of circuit elements and corresponding ones of the plurality of pins having functionally critical timing dependencies, and the certain ones of the circuit elements including bi-directional driver/receiver elements interposed between a corresponding pin and others of the certain ones of the circuit elements, the driver/receiver elements being available for incircuit test control signals applied through the pins for enabling and disabling the driver/receiver elements for permitting normal functional passage of signals in one direction through an associated pin and for permitting testing by passage of signals in an opposite direction through an associated pin;

mounting the integrated circuit on a printed circuit board having a plurality of conductive pathways supported by said board for connection to the integrated circuit device;

connecting the pins with the conductive pathways;

testing the connections between the pins and the pathways by applying test control signals through the conductive pathways for disabling the driver/receiver elements and permitting testing by passage of signals through the associated pin in a direction opposite to normal functional passage of signals through the associated pin; and

removing the test control signals for enabling the driver/receiver elements to permit normal functional passage of signals through an associated pin.

9. A method of testing a personal computer planar board for proper connection of the pins provided on an integrated circuit device mounted on the board and comprising the steps of:

providing an integrated circuit device having:

a package;

a plurality of pins extending from the package for providing input and output pathways for signals exchanged with the integrated circuit device;

a substrate housed within the package; and

a plurality of connected circuit elements operatively associated with the substrate and with one another for performing determinable functions, the circuit elements being operatively associated with the pins for exchange of signals therethrough, certain ones of the plurality of circuit elements and corresponding ones of the plurality of pins having functionally critical timing dependencies, and the certain ones of the circuit elements including bi-directional driver/receiver elements interposed between a corresponding pin and others of the certain ones of the circuit elements, the driver/receiver elements being available for incircuit test control signals applied through the pins for enabling and disabling the driver/receiver elements for permitting normal functional passage of signals in one direction through an associated pin and for permitting testing by passage of signals in an opposite direction through an associated pin;

mounting the integrated circuit on a planar board having a plurality of conductive pathways supported by said board for connection to the integrated circuit device;

connecting the pins with the conductive pathways;

testing the connections between the pins and the pathways by applying test control signals through the conductive pathways for disabling the driver/receiver elements and permitting testing by passage of signals through the associated pin in a direction opposite to normal functional passage of signals through the associated pin; and

removing the test control signals for enabling the driver/receiver elements to permit normal functional passage of signals through an associated pin.

*Fig. 1*

EP 0 518 550 A2

_Fig. 2_

_Fig. 3_

critical
output
pin

bus
driver

functional path ————————————▷—————— ☐

_Fig. 4_

functional path ——————┐

mux

critical
output
pin

bus
driver

——▷———— ☐

input   I/O mapping
pin     test path

ICT control ——————————

_Fig. 5_

ICT control ——————————┐
(tristates driver)

critical
output
pin

o

functional path ————————————▷—————— ☐

_60_

I/O mapping test path ————————◁——

mux

bus
driver

_61_

☐ ——◁——

non-critical
output
pin

non-critical output data

ICT control

_Fig. 6_

11

critical
input
pin

receiver

internal loading

*Fig. 7*

functional path

critical
input
pin

mux

bus
driver

output
pin

receiver

functional
internal
loading

mux adds additional
loading to receiver

ICT control

*Fig. 8*

critical
input
pin

62

internal loading

from a receiver

ICT control
(enables driver)

*Fig. 9*